# EUROPÄISCHE PATENTSCHRIFT

(11) **EP 2 462 457 B1**
(45) Veröffentlichungstag und Bekanntmachung des Hinweises auf die Patenterteilung: **11.11.2015**
(21) Anmeldenummer: 10740549.0
(22) Anmeldetag: 28.07.2010
(51) Int. Cl.: H01M 10/0525, H01M 10/48, G01R 31/36

(54) **VERFAHREN ZUM STEUERN EINER BATTERIE UND VORRICHTUNG ZUR DURCHFÜHRUNG DES VERFAHRENS**
METHOD FOR CONTROLLING A BATTERY AND DEVICE FOR IMPLEMENTING THE METHOD
PROCÉDÉ POUR COMMANDER UNE BATTERIE ET DISPOSITIF POUR LA MISE EN OEUVRE DU PROCÉDÉ

(30) Priorität: 04.08.2009 DE 102009036083
(43) Veröffentlichungstag der Anmeldung: 13.06.2012
(73) Patentinhaber: Li-Tec Battery GmbH, 01917 Kamenz (DE)
(72) Erfinder: HAHN, Elke, 01099 Dresden (DE); KAISER, Joerg, 01917Kamenz (DE); GUTSCH, Andreas, 59348 Luedinghausen (DE)
(74) Vertreter: JENSEN & SON
(86) Internationale Anmeldenummer: PCT/EP2010/004634
(87) Internationale Veröffentlichungsnummer: WO 2011/015307

(56) Entgegenhaltungen:
- DE-A1-102004 053 977
- FR-A1- 2 881 529
- US-B1- 6 417 670
- KIM H ET AL: "On Dynamic Reconfiguration of a Large-Scale Battery System", REAL-TIME AND EMBEDDED TECHNOLOGY AND APPLICATIONS SYMPOSIUM, 2009. RTAS 2009. 15TH IEEE, IEEE, PISCATAWAY, NJ, USA, 13. April 2009 (2009-04-13), Seiten 87-96, XP031450847, ISBN: 978-0-7695-3636-1
- SONG CI ET AL: "A Novel Design of Adaptive Reconfigurable Multicell Battery for Power-Aware Embedded Networked Sensing Systems", GLOBAL TELECOMMUNICATIONS CONFERENCE, 2007. GLOBECOM '07. IEEE, IEEE, PISCATAWAY, NJ, USA, 1. November 2007 (2007-11-01), Seiten 1043-1047, XP031196129, ISBN: 978-1-4244-1042-2
- ALAHMAD ET AL: "Battery switch array system with application for JPL's rechargeable micro-scale batteries", JOURNAL OF POWER SOURCES, ELSEVIER SA, CH, Bd. 177, Nr. 2, 23. November 2007 (2007-11-23), Seiten 566-578, XP022450305, ISSN: 0378-7753, DOI: DOI:10.1016/J.JPOWSOUR.2007.11.053
- VISAIRO H ET AL: "A reconfigurable battery pack for improving power conversion efficiency in portable devices", DEVICES, CIRCUITS AND SYSTEMS, 2008. ICCDCS 2008. 7TH INTERNATIONAL CARIBBEAN CONFERENCE ON, IEEE, PISCATAWAY, NJ, USA, 28. April 2008 (2008-04-28), Seiten 1-6, XP031272594, ISBN: 978-1-4244-1956-2

## Beschreibung

Die vorliegende Erfindung betrifft ein Verfahren und eine Vorrichtung zur Steuerung von Betriebszuständen einer Batterie aus elektrochemischen Zellen. Aufgrund der Empfindlichkeit von elektrochemischen Energiespeichern, wie insbesondere Lithium-Ionen-Zellen und Lithium-Ionen-Batterien gegenüber belastenden und schädigenden Betriebszuständen und der damit einhergehenden beschleunigten Alterung dieser Energiespeicher, sind diese üblicherweise mit einem sog. Batteriemanagementsystem bzw. mit einer Schutzschaltung ausgestattet, das bzw. die schädigende Betriebszustände, wie sie durch die Nutzung einer Batterie oder Zelle außerhalb vorgegebener, beispielsweise durch Spannungsgrenzen, Stromgrenzen oder Temperaturgrenzen definierten Betriebsbereiche entstehen können, verhindert.

Die US 5,617,324 beschreibt eine Einrichtung zur Messung der Restbatteriekapazität, die sich einer Einrichtung zur Berechnung des Spannungs-Strom-Zusammenhangs zur Entdeckung dispersiver" Klemmenspannungen und Entladungsströme einer Batterie bedient. Eine Einrichtung zur Berechnung eines näherungsweisen linearen Zusammenhangs ("approximate linear function") zwischen Klemmenspannungen und Entladungsströmen und zur Berechnung eines Korrelationskoeffizienten zwischen diesen Größen wird verwendet, um zu entscheiden, ob ein berechneter Korrelationskoeffizient, verringert um einen negativen Referenzwert, stetig berechnet werden kann.

Die US 6,366,054 beschreibt ein Verfahren zur Bestimmung des Ladungszustandes (SoC) einer Batterie durch Messung einer Leelaufspannung (OCV) im Ruhezustand chemischen und elektrischen Gleichgewichts oder in einem Nichtgleichgewichtszustand, in dem die Batterie sich nach der Beendigung eines Lade- oder Entladevorgangs wieder einem Gleichgewichtszustand annähert. Dabei wird ein erster Algorithmus eingesetzt, um die Leerlaufspannung im Gleichgewicht mit dem Ladungszustand zu korrelieren, in dem diese Messung durchgeführt wird. Ein zweiter Algorithmus dient dazu, die Gleichgewichtsleerlaufspannung einer Batterie vorherzusagen auf der Grundlage der Leerlaufspannung, ihrer zeitlichen Änderungsgeschwindigkeit und der Batterietemperatur in der Nichtgleichgewichtsphase.

Die US 7,072,871 beschreibt ein System zur Bestimmung des Gesundheitszustandes von Batterien mit einer adaptiven Komponente. Das System testet eine Batterie durch Messung einer Anzahl von elektrochemischen Parametern und bedient sich der Fuzzy-Logik um den Gesundheitszustand der Batterie zu berechnen.

Die EP 1 109 028 beschreibt ein Verfahren zur Überwachung der Restladung und der Leistungsfähigkeit einer Batterie, bei dem an der belasteten Batterie mindestens zwei Strom-Spannungsmessungen im Hochstrombereich durchgeführt werden. Die erste Strom-Spannungsmessung wird zu einem ersten Zeitpunkt bei einem ersten Belastungszustand der Batterie gemessen. Eine zweite Strom-Spannungsmessung wird zu einem zweiten Zeitpunkt bei einem zweiten Belastungszustand der Batterie durchgeführt. Wesentlich ist, dass sich hierbei der Belastungszustand der Batterie durch den entnommenen Strom geändert hat. Die Stromspannungsmessungen ergeben einen ersten Messpunkt und einen zweiten Messpunkt. Durch die beiden Messpunkte wird eine Interpolationsgerade gelegt und deren Schnittpunkt mit einem Grenzspannungsniveau (UGr) ermittelt. Dieser Schnittpunkt ist gekennzeichnet durch einen sogenannten Grenzstrom (IGr). Das Grenzspannungsniveau ist bestimmt aus der Mindestspannung, die die angeschlossenen Verbraucher benötigen, um fehlerfrei zu funktionieren. Das Grenzspannungsniveau wird daher bei der technischen Auslegung des Batterienetzes vorgegeben und ist bekannt.

Die DE 102 08 652 beschreibt ein Verfahren zur Ladezustandserfassung einer Batterie, bei dem wenigstens zwei Messwertepaare für Spannung und Strom erfasst und auf Werte, die sich im thermisch eingeschwungenen Zustand ergeben, korrigiert werden. Diese erfassten Messwerte werden interpoliert, und es wird ein Ruhespannungswert und der Ladezustand ermittelt mittels eines vorgegebenen Zusammenhangs zwischen ermittelter Ruhespannung und dem Ladezustand.

Die DE 197 50 309 beschreibt ein Verfahren zur Bestimmung der Startfähigkeit einer Starterbatterie eines Kraftfahrzeugs, bei dem der Mittelwert des Spannungseinbruchs beim Starten des Verbrennungsmotors gemessen und mit den Spannungswerten eines Kennlinienfeldes, welches aus gemessenen Spannungseinbrüchen und zugehörigen Batterie- sowie Motortemperaturen besteht, verglichen wird.

Die DE 40 07 883 beschreibt ein Verfahren und Batterieprüfgerät zum Bestimmen des Zustands einer Bleibatterie. Dabei wird in einem Entladezyklus ein stabiler Zustand der Batterie herbeigeführt und anschließend eine Entladung mit hohem Entladestrom durchgeführt. Anhand von den für den entsprechenden Batterietyp gespeicherten Vergleichskurven wird aufgrund der an der stabilisierten Batterie und nach dem Fließen des hohen Entladestroms ermittelten Messwerte unter Berücksichtigung der Temperatur der Verlust der Startfähigkeit oder die Startfähigkeit angezeigt.

Die FR 2 881 529 A1 offenbart ein System und ein Verfahren zur Schätzung des Ladezustands einer Batterie mit einem Sensor zum Messen der Klemmenspannung der Batterie, einem Sensor zum Messen des Stroms durch die Batterie, einem Steuermodul und einem Speicher mit einer Vielzahl von Zustandswerten, geschätzten Lastwerten und einer Vielzahl von Spannungs- und Stromwerten entsprechend jedem Ladezustand. Es ist eine Einheit zur Schätzung des Ladezustands vorgesehen und ein Modul zur Berechnung von Zwischenwerten des Lastzustand durch Interpolation der für zwei Temperaturwerte in dem Speicher gespeicherten Werte von Strom und Spannung.

Die Veröffentlichung von KIM H et al: "On Oynamic Reconfiguration of a Large-Scale Battery System", REAL-TIME AND EMBEDDED TECHNOLOGY AND APPLICATIONS SYMPOSIUM, 2009. RTAS 2009. 15TH IEEE, IEEE, PISCATAWAY, NJ, USA, 13. April 2009 (2009-04-13), Seiten 87-96, XP031450847, ISBN: 978-0-7695-3636-1 offenbart ein Verfahren zur dynamischen Rekonfiguration von Batteriesystemen mit einer großen Zahl von Batteriezellen ("Large-Scale Battery Systems"). Ziel ist die Erhöhung der Toleranz des Systems gegen Ausfälle von Batteriezellen ("fault-tolerance"). Hierzu wird ein "syntaktischer" Umgehungsmechanismus ("syntactic bypassing mechanism") ausgefallener Batteriezellen vorgeschlagen.

Die Veröffentlichungen von Ci S et al: "A Novel Design of Adaptive Reconfigurable Multicell Battery for Power-Aware Embedded Networked Sensing Systems", GLOBAL TELECOMMUNICATIONS CONF, 2007. GLOBECOM 2007. IEEE, IEEE, PISCATAWAY, NJ, USA, 1. November 2007 (2007-11-01), Seiten 1043-1047, XP031196129, ISBN : 978-1-4244-1042-2, von Alahmad et al: "Battery switch array system with application for JPL's rechargeable micro-scale batteries", JOURNAL OF POWER SOURCES, ELSEVIER SA, CH, Bd. 177, Nr. 2, 23. November 2007 (2007-11-23), Seiten 566-578, XP 022450305, ISSN: 0378 - 7753 und von Visairo H et al: "A reconfigurable battery pack for improving power conversion efficiency in portable devices" ,DEVICES, CIRCUITS AND SYSTEMS, 2008. ICCDCS 2008. 7TH INTL. CARIBBEAN CONFERENCE ON, IEEE, PISCATAWAY, NJ, USA, 28. April 2008 (2008-04-28), Seiten 1-6, XP031272594, ISBN:978-1-4244-1956-2 offenbaren verschiedene Verfahren zur Rekonfiguration von Batterien.

Batteriemanagementsysteme bedienen sich solcher oder ähnlicher Verfahren oder Einrichtungen zur Steuerung oder Regelung von Batteriebetriebszuständen. Häufig greifen diese Batteriemanagementsysteme oder Schutzschaltungen ein, indem das Batteriemanagement die Batterie oder eine Zelle in der Batterie abschaltet oder die Leistung der Batterie auf ein die Zellen nicht schädigendes Niveau begrenzt. Hierdurch können jedoch die Möglichkeiten des Anwenders bei der Nutzung der Batterie in unerwünschter Weise beschränkt werden.

Der vorliegenden Erfindung liegt die Aufgabe zugrunde, ein verbessertes Verfahren zum Steuern einer Batterie oder eine verbesserte Vorrichtung zur Durchführung eines solchen Verfahrens anzugeben. Diese Aufgabe wird durch ein Verfahren oder eine Vorrichtung zur Steuerung von Betriebszuständen einer Batterie oder durch ein Verfahren zur Konfiguration einer Batterie nach einem der unabhängigen Patentansprüche gelöst.

Erfindungsgemäß ist vorgesehen, dass die Steuerung der Betriebszustände einer Batterie oder ihrer elektrochemischen Zellen auf der Grundlage einer Bewertung dieser Betriebszustände erfolgt. Diese Bewertung wird dabei mit Hilfe von Approximationsfunktionen gewonnen, mit deren Hilfe Bewertungen für zweite Betriebszustände, für die keine oder keine vollständigen Messdaten über das Verhalten der Batterie vorliegen, durch Interpolation aus Messdaten für erste Betriebszustände, für die Messdaten über das Verhalten der Batterie vorliegen, ermittelt werden.

Eine Batterie im Sinne der vorliegenden Erfindung ist eine Reihen- und/oder Parallelschaltung einer Mehrzahl von Zellen oder auch nur eine einzelne Zelle. Unter einer Zelle soll dabei eine "galvanische Zelle", also ein elektrochemischer Energiespeicher verstanden werden. Dabei kann es sich um wiederaufladbare Sekundärzellen oder nicht wiederaufladbare Primärzellen handeln. Nachstehend wird der Einfachheit halber gelegentlich, wenn sich aus dem Zusammenhang nichts anderes ergibt, der Begriff Batterie auch für eine einzelne Zelle verwendet, die ja auch als einzellige Batterie aufgefasst werden kann. Wenn in dieser Anmeldung von einem Energiespeicher oder von einem elektro-chemischen Energiespeicher die Rede ist, ist damit eine einzelne Zelle oder eine Batterie aus einer Mehrzahl von Zellen gemeint.

Ein Betriebszustand einer einzelnen Zelle oder einer Batterie aus einer Mehrzahl von elektrochemischen Zellen wird durch Betriebszustandsgrößen charakterisiert. Beispiele für solche Betriebszustandsgrößen sind die Spannung, der Widerstand (Innenwiderstand), die Temperatur, der Ladestrom oder der Entladestrom. Andere Betriebszustandsgrößen sind dem Fachmann geläufig und im Zusammenhang mit Ausführungsbeispielen der vorliegenden Erfindung möglich.

Ein Betriebszustand ist durch einen Satz von geeigneten Betriebszustandsgrößen, wie z.B. Ladeströme, Entladeströme, Spannungen, Widerstände, Temperaturen oder Ähnliches charakterisiert. Der Begriff der "Betriebszustandsgröße" entspricht dabei dem im Bereich der Technik ebenfalls geläufigen Begriff des "Betriebsparameters" einer Zelle oder einer Batterie. Welche Sätze von Betriebszustandsgrößen (Betriebsparametern) zur Charakterisierung eines Betriebszustands einer Zelle oder Batterie jeweils geeignet sind und deshalb zweckmäßig verwendet werden, hängt von der betrachteten zugrundeliegenden Technologie und von den elektrochemischen Modellen ab, die zur physikalisch technischen Charakterisierung dieser Technologie jeweils herangezogen werden.

Unter der Bewertung eines Betriebszustands soll im vorliegenden Zusammenhang eine qualitative oder quantitative Zuordnung verstanden werden, die einem oder mehreren möglichen oder tatsächlichen Betriebszuständen einer Batterie ein Maß oder einen Hinweis für die Alterung oder Schädigung der Batterie oder ihrer Zellen zuordnet. Solche Bewertungen können aus Alterungskurven einzelner Zellen oder Batterien bestehen, die durch Messungen in einer begrenzten Zahl von ersten Betriebszuständen gewonnen wurden. Beispiele für Alterungskurven sind funktionale Zuordnungen von Daten, welche die Alterung oder Schädigung charakterisieren zu einer Mehrzahl von ersten Betriebszuständen. Durch Interpolation zwischen (oder durch Extrapolation aus) diesen Messwerten können dann Bewertungen auch für zweite Betriebszustände abgeleitet werden, für die keine Messungen durchgeführt wurden. Aus Gründen der sprachlichen Einfachheit soll der Begriff der Interpolation - falls sich aus dem Zusammenhang nicht etwas gegenteiliges ergibt - stets auch die Extrapolation einschließen, zumal beide Verfahren aus mathematischer und technischer Sicht nicht grundsätzlich verschieden sind.

Unter der Steuerung der Betriebszustände einer Batterie oder Zelle sollen alle Maßnahmen verstanden werden, mit denen die Betriebszustandsgrößen der gesteuerten Batterie oder Zelle beeinflusst werden können. Hierzu zählt insbesondere eine Verringerung der Belastung einer Batterie oder Zelle, die Herausnahme einer Zelle aus dem Batterieverbund, ihre Kühlung oder andere Maßnahmen, die geeignet sind, den Betriebszustand einer Batterie zu beeinflussen.

Erste Betriebszustände im Sinne der vorliegenden Erfindung sind dabei Betriebszustände, für die Messdaten für das Verhalten der Batterie oder der Zelle in solchen Betriebszuständen, insbesondere über das Alterungsverhalten der Batterie oder der Zelle in solchen Betriebszuständen, vorliegen. Zweite Betriebszustände sind dagegen Betriebszustände, die durch die Art der Nutzung einer Batterie oder der Zelle von dieser Batterie oder dieser Zelle eingenommen werden können, für die jedoch solche Messdaten nicht verfügbar sind.

Approximationsfunktionen im Sinne der Beschreibung der vorliegenden Erfindung sind parametrisierte Funktionen, also Funktionen, die von einem Parameter oder von mehreren Parametern und von Betriebszustandsgrößen abhängen, die aufgrund ihrer mathematischen Eigenschaften geeignet sind, eine größere Zahl von Messdaten, die für erste Betriebszustände einer Batterie ermittelt wurden, durch geeignete Wahl ihrer Parameter anzunähern (zu approximieren), so dass die den Messdaten entsprechenden Größen für zweite Betriebszustände der Batterie, in denen diese Messdaten nicht vorliegen, mit Hilfe dieser Approximationsfunktionen durch eine Interpolation ermittelt werden können. Approximationsfunktionen sind Funktionen von Betriebszustandgrößen und (weiteren) Parametern. Von diesen Veränderlichen können die Approximationsfunktionen in linearer oder nicht linearer Weise abhängen. Nicht lineare (oder: nicht-lineare) funktionale Abhängigkeiten eröffnen einen weitaus größeren Raum möglicher funktionaler Formen und damit eine erheblich größere Flexibilität als eine Beschränkung auf lineare funktionale Abhängigkeiten. Der Preis für diese höhere Flexibilität ist häufig in Form eines erhöhten Rechenaufwandes bei der Bestimmung der optimalen Parameterwerte zu zahlen.

Diese Parameter, von denen die Approximationsfunktionen neben den Betriebszustandsgrößen abhängen, und deren Werte so bestimmt werden, dass die Approximationsfunktionen die Messdaten möglichst gut "approximieren", sind begrifflich zu trennen von den "Betriebsparametern". Die sogenannten Betriebsparameter sind Betriebszustandsgrößen, charakterisieren also Betriebszustände. Die Parameter der Approximationsfunktionen sind keine Betriebszustandsgrößen; ihre Werte werden so gewählt, dass die Approximationsfunktionen die Messdaten möglichst gut repräsentieren. Dem steht nicht entgegen, dass die funktionale Abhängigkeit der Approximationsfunktionen von ihren Variablen (Betriebszustandsgrößen und Parametern) im Einzelfall durch physikalische oder elektrochemische Modellvorstellungen motiviert sein kann, in denen einzelnen oder mehreren Parametern die Bedeutung von Betriebszustandsgrößen zukommt, die dann jedoch im Rahmen der Verwendung dieser speziellen Approximationsfunktionen nicht beobachtet (d.h. nicht gemessen) werden.

Messdaten im Sinne der Beschreibung der vorliegenden Erfindung sind Betriebszustandsgrößen und/oder andere vorzugsweise physikalische, technische oder chemische Größen, die geeignet sind das Verhalten, insbesondere das Alterungsverhalten oder die Schädigung einer Zelle oder einer Batterie in einem Betriebszustand zu charakterisieren. Beispiele für solche Messdaten sind die Kapazität, insbesondere die verbleibende Kapazität, die Strombelastbarkeit, beispielsweise charakterisiert durch die Änderung der Klemmenspannung mit dem Entladestrom, oder ähnliche Größen.

Vorteilhafte Weiterbildungen der Erfindung sind Gegenstände von Unteransprüchen.

Im Folgenden wird die Erfindung anhand bevorzugter Ausführungsbeispiele näher beschrieben.

Die Erfindung geht davon aus, dass für verschiedene Betriebszustände von Zellen oder von Batterien, die durch geeignete Betriebszustandsgrößen wie z.B. Ladeströme, Entladeströme, Spannungen, Widerstände, Temperaturen oder Ähnliches gegeben sind, das Alterungsverhalten einzelner Zellen, beispielsweise von sogenannten Lithium-Ionen-Zellen, oder ganzer Verbände ("Batterien") aus mehreren solcher Zellen gemessen wurde. Da solche Messungen aus praktischen Gründen stets nur für eine begrenzte (endliche) Anzahl von Betriebszuständen möglich sind, können auf diese Weise keine durchgehenden Kurven oder - im praktisch bedeutsamen Fall von mehreren Betriebszustandsgrößen - (Hyper-)Flächen von Funktionen ermittelt werden, die das Alterungsverhalten für beliebige Betriebszustände beschreiben.

Stattdessen werden nur für relativ wenige ausgewählte, für die Messung benutzte Betriebszustände Messgrößen ermittelt, aus denen ein vorzugsweise quantitatives Maß für die Alterung oder Schädigung von Zellen oder ganzen Batterien in den jeweiligen Betriebszuständen abgeleitet werden kann. Dabei muss es sich nicht unbedingt um ein quantitatives, also zahlenmäßig feststehendes Maß handeln; stattdessen kann es sich auch um eine qualitative Bewertung des Alterungsverhaltens oder Alterungszustands oder einer Schädigung eines Energiespeichers handeln, die z.B. durch Adjektive wie "stark", "schwach", "alt", "neu" oder solchen Adjektiven zugeordnete Indexzahlen charakterisiert werden kann.

Beispielsweise die US 7,072,871 beschreibt ein System zur Bestimmung des Gesundheitszustandes von Batterien mit einer adaptiven Komponente. Das System testet eine Batterie durch Messung einer Anzahl von elektrochemischen Parametern und bedient sich der Fuzzy-Logik um den Gesundheitszustand der Batterie zu berechnen. Darin werden, wie es für die sogenannte Fuzzy Logik charakteristisch ist, qualitative Bewertungen wie "R-GOOD", "R-EXCELLENT" oder "R-POOR" mit Hilfe sogenannter "membership functions" (zu Deutsch etwa: Zugehörigkeitsfunktionen") von Batteriezuständen vorgenommen, die beispielsweise (siehe Fig. 5B der US 7,072,871) durch numerische Werte des Innenwiderstandes oder anderer Betriebszustandsgrößen charakterisiert werden. Die Fig. 5A der US 7,072,871 zeigt das allgemeine Prinzip solcher qualitativen Bewertungen mit Hilfe von Methoden der Fuzzy Logik.

Obwohl in der Regel quantitative Bewertungen von Betriebszuständen eine größere Bedeutung haben werden als qualitative Bewertungen, ist die vorliegende Erfindung nicht auf eine von beiden Methoden beschränkt, sondern kann im Zusammenhang mit jeder dieser beiden Methoden verwendet werden. Für die vorliegende Erfindung ist es von Bedeutung, dass aufgrund solcher Messungen in ersten Betriebszuständen Hinweise oder Maße oder Maßzahlen für das Alterungsverhalten des Energiespeichers, d.h. der Batterie oder einer einzelnen Zelle abgeleitet werden können.

Im Allgemeinen wird die Zahl der ersten Betriebszustände, die für die Messungen zur Verfügung stehen, viel geringer sein als die Zahl der Betriebszustände, in denen ein Anwender den betreffenden Energiespeicher in einer bestimmten Anwendungssituation betreiben will. Für ein Betriebbatteriemanagement, das einem Anwender den Betrieb einer Batterie in möglichst flexibler Weise ermöglichen soll, werden daher Steuerungen benötigt, die auch eine Steuerung in Betriebszuständen ermöglichen, für die keine Messdaten vorliegen. Wenn, wie im vorliegenden Fall, die Steuerung auf der Grundlage einer Bewertung des Alterungsverhaltens oder der Schädigung eines Energiespeichers erfolgen soll, ist es erforderlich, auch für solche Betriebszustände über eine entsprechende Bewertung zu verfügen, für die eine Bewertung durch Messungen nicht möglich war oder nicht vorgenommen wurde.

Die vorliegenden Erfindung geht - im Gegensatz zu einigen bekannten, teilweise in der Beschreibungseinleitung erwähnten Verfahren - nicht davon aus, solche Bewertungen durch Hochstrommessungen bestimmen zu müssen, obwohl solche Messungen im Rahmen der vorliegenden Erfindung auch nicht ausgeschlossen sind. Hochstrommessungen sind jedoch in aller Regel für die Batterie belastender als Niedrigstrommessungen; außerdem gehen sie mit nicht vernachlässigbaren Energieverlusten für die eigentliche Anwendung der Batterie einher, so dass es in vielen Fällen wünschenswert erscheint, solche Hochstrommessungen zu vermeiden.

Die vorliegende Erfindung sieht nun vor, eine solche Bewertung für die zweiten Betriebszustände, in denen keine Messungen vorgenommen wurden, durch eine Interpolation von Bewertungen von ersten Betriebszuständen zu ermitteln. Diese Interpolationen sollen erfindungsgemäß mit Hilfe von Approximationsfunktionen vorgenommen werden, die das Alterungs- oder Schädigungsverhalten von Energiespeichern für beliebige technisch mögliche oder wenigstens für technisch und praktisch relevante Betriebszustände beschreiben, und die die gemessenen Bewertungen der ersten Betriebszustände möglichst gut wiedergeben.

Wie dem Fachmann aus vielen Bereichen der Technik grundsätzlich bekannt ist, werden solche Approximationsfunktionen gewöhnlich durch Minimierung eines Fehlermaßes an die Messdaten angepasst, indem man den Fehler, d.h. die Abweichung zwischen den Funktionswerten der Approximationsfunktionen und den Messwerten in den ersten Betriebszuständen minimiert. Unter der häufig plausiblen und in vielen wichtigen Fällen zutreffenden Annahme, dass die Bewertungen stetige Funktionen der Betriebszustandsgrößen sind, sollten die Werte der Approximationsfunktionen für Betriebszustandsgrößen, die den zweiten Betriebszuständen entsprechen, in denen also keine Messungen vorliegen, die tatsächlichen Verhältnisse des Alterungsverhaltens oder der auftretenden Schäden in solchen Betriebszuständen zutreffend beschreiben. Die Abweichungen zwischen den Werten der Approximationsfunktionen und den Messdaten werden bei der Ermittlung der Approximationsfunktionen durch Variation ihrer Parameter ermittelt. Die Parameter werden dabei so eingestellt, dass das verwendete Fehlermaß, beispielsweise die (gegebenenfalls geeignet gewichtete) Summe der quadratischen Abweichungen oder ein ähnliches Fehlermaß, minimal ist.

Wo die Annahme der stetigen Abhängigkeit der Approximationsfunktionen von den Betriebszustandsgrößen nicht erfüllt ist, können geeignet gewählte Typen von Approximationsfunktionen zum Einsatz kommen, deren Sprungstellen, Polstellen oder andersartige Singularitäten durch geeignete Wahl ihrer Parameter so gelegt wurden, dass sie diese tatsächlichen Verhältnisse in ausreichender Näherung wiedergeben.

Eine verbreitete Methode zur Ermittlung geeigneter Parameterwerte von Approximationsfunktionen im Falle numerischer Werte ist beispielsweise die Minimierung der Summe der kleinsten Fehlerquadrate. Je nach Anwendungsfall sind dem Fachmann aber auch fortschrittlichere Verfahren bekannt, bei denen eine unterschiedliche Gewichtung der einzelnen Messdaten möglich ist, die die Zuverlässigkeit oder Fehlerhaftigkeit der Messdaten in angemessener Weise berücksichtigen soll. Im Rahmen der vorliegenden Beschreibung der vorliegenden Erfindung ist darauf nicht näher einzugehen. Es sei stattdessen auf die umfangreiche Literatur zur numerischen Approximation verwiesen.

Geeignete Funktionstypen für Approximationsfunktionen findet der Fachmann häufig auf der Grundlage von physikalischen oder elektrochemischen Modellvorstellungen, die bestimmte, meist nur näherungsweise gültige, "gesetzmäßige" Zusammenhänge zwischen Betriebszustandgrößen von Batterien oder einzelnen Zellen implizieren. Ein Beispiel für solche "gesetzmäßigen" Zusammenhänge mag die sogenannte Peukert-Gleichung (Vieweg, "Handbuch Kraftfahrzeugtechnik", herausgegeben von Hans-Hermann Braess, Ulrich Seiffert, Mitwirkende Personen Hans-Hermann Braess, Edition: 5, veröffentlicht im Vieweg-Teubner-Verlag, 2007, ISBN 3834802220, 9783834802224, 923 Seiten, beispielsweise Seite 330) sein, die einen empirischen Zusammenhang zwischen der entnehmbaren Ladung einer Batterie und dem Enladestrom liefert.

Grundsätzlich können auch nichtnumerische Bewertungen durch Approximationsfunktionen interpoliert werden. Auch auf die Grundlagen dieser Möglichkeiten soll in der vorliegenden Beschreibung nicht näher eingegangen werden. Stattdessen sei auf die Literatur hierzu verwiesen beispielsweise auf die Monographie "Computing with Words in Information" von Lofty A. Zadeh und Janusz Kacprizyk, veröffentlicht im Springer Verlag 1999, ISBN 379081217X bzw. auf die Monographie "Introduction to Approximation Theory" von Eliot Ward Cheney, American Mathematic Society, edition 2, published AMS Bookstore, 1998, ISBN 0281813749.

Mit Hilfe solcher Approximationsfunktionen lassen sich auch Batteriesysteme aus mehreren Einzelzellen gezielt nach den individuellen Anforderungsprofilen von Anwendern in Bezug auf die elektrische Leistung oder ihre Lebensdauer auslegen ("konfigurieren"), indem die Zellen einer Batterie in geeigneter Weise parallel und/oder seriell verschaltet werden, ohne das Batteriesystem dabei in unwirtschaftlicher Weise zu dimensionieren ("Überdimensionierung").

Außerdem kann ein Batteriemanagementsystem oder eine hierin enthaltene Schutzelektronik mit Hilfe der in oben bezeichneter Weise gewonnenen Approximationsfunktionen so ausgestaltet werden, dass es bzw. sie Betriebszustände erkennt, welche die Zellen eines Batteriesystems überdurchschnittlich belasten und/oder unerwünscht schnell altern lassen.

Darauf aufbauend lassen sich insbesondere bei Batterien, die einem Anwender für eine begrenzte Zeit leihweise überlassen werden, entsprechende dynamische Preismodelle entwickeln, bei denen der Anwender ("Leasingnehmer") einen Preis zu entrichten hat, der abhängig ist von den Schädigungen oder von den Alterungen, die eine Batterie durch seine Anwendung erlitten hat. Dieser Anwender hat daher eine höhere Flexibilität bei der Anwendung der Batterie, als wenn das Batteriemanagementsystem oder die Schutzelektronik die Batterie einfach abschalten oder ihre Nutzung begrenzen würde. Stattdessen kann der Anwender selbst entscheiden, in welcher Weise er die Batterie nutzen möchte, muss jedoch einen höheren Preis für die Benutzung der Batterie bezahlen, wenn mit der von ihm vorgenommenen Nutzung entsprechende Schäden oder eine erhöhte Alterung verbunden sind.

Bei einer bevorzugten Ausführungsform der Erfindung wird ein quantitatives Maß für die Alterung oder Schädigung von Zellen oder Batterien von Zellen für die Bewertung eines Betriebszustands herangezogen. Beispiele für solche quantitativen Maße sind die absolute oder relative Restlebensdauer, die absolute oder relative verfügbare Kapazität, oder ähnliche Größen, die geeignet sind, den Alterungszustand oder Beschädigungen eines Energiespeichers zu beschreiben. Vorzugsweise geben diese Maße die Alterung oder Schädigung pro Zeiteinheit in dem jeweiligen Betriebszustand an, dem sie zugeordnet werden. Diese bevorzugte Ausführungsvariante der Erfindung hat den Vorteil, dass bei, nach oder vor dem Durchlaufen einer Folge von Batteriezuständen durch zeitliche Integration dieser zustandspezifischen Alterungsgeschwindigkeitsmaße die (integrale) durch das Durchlaufen dieser Zustandsfolge bedingte Batterie- oder Zellenalterung oder-Schädigung festgestellt werden kann. Damit ist es möglich, den Anwender bei der Planung seiner Anwendung entsprechend über deren Konsequenzen für die Batteriealterung zu instruieren und ggf. ihm die Kosten für die durch die von ihm geplante oder durchgeführte Anwendung aufzuerlegen.

Diese Instruierung oder Information des Anwenders über die Konsequenzen seiner Nutzung der Batterie für die Batteriealterung kann auch auf automatische Weise während der laufenden Anwendung und vorzugsweise so geschehen, dass eine programmierte Anwendungssteuerung diese Informationen auswertet und dazu verwendet, vom Anwender vorgegebene Ziele zu optimieren oder Randbedingungen zu beachten.

Die Steuerung wird erfindungsgemäß vorzugsweise so ausgelegt, dass ein quantitatives Maß für die Alterung oder Schädigung von Zellen oder Batterien aus Zellen minimiert wird. Es ist aber auch möglich, die Minimierung so durchzuführen, dass ein Betriebszustand gesucht wird, in dem die Alterungsrate oder Schädigungsrate pro Zeiteinheit minimal oder geringer ist als in einem momentanen tatsächlich eingenommenen Betriebszustand. Eine andere Möglichkeit besteht darin, ein über die Zeit integriertes Maß für die Alterung oder Schädigung des Energiespeichers zu minimieren. Auch Kombinationen dieser Vorgehensweisen sind möglich. Welche Verfahrensweise vorzuziehen ist, hängt von der jeweiligen Anwendungssituation ab.

Es sind auch Anwendungssituationen möglich, in denen die ausschließliche Minimierung von Alterungskriterien oder Schädigungen eines Energiespeichers nicht zweckmäßig ist. In solchen Situationen wird vorzugsweise eine Zielgröße optimiert, die neben wenigstens einem quantitativen Maß für die Alterung oder Schädigung von Zellen noch wenigstens eine weitere Funktion von Betriebszustandsgrößen der Batterie umfasst. Solche komplexeren Zielgrößen können sich beispielsweise dadurch ergeben, dass bei der Steuerung Randbedingungen zu beachten sind wie z.B. das Kriterium, dass eine bestimmte abgegebene Leistung nicht unterschritten oder überschritten werden darf. Bei wiederum anderen Anwendungen ist es möglich, dass die zu optimierende Zielgröße sich als Kombination aus einem Maß für die Alterung oder Schädigung einerseits und einem anderen Maß für die Leistungsfähigkeit, beispielsweise für die abgegebene Leistung, für die verbleibende Batteriekapazität oder ähnliche Größen zusammensetzt.

Vorzugsweise werden bei vielen Ausführungsformen der vorliegenden Erfindung Batteriezustände durch mindestens eine der Betriebszustandsgrößen Batteriespannung, Widerstand, Temperatur, Ladestrom oder Entladestrom charakterisiert. Je nach verwendeter Batterietechnologie können andere Betriebszustandsgrößen zur Charakterisierung des Betriebszustands eines Energiespeichers geeignet sein. Die Erfindung ist nicht auf eine Anwendung im Zusammenhang mit Lithium-Ionen-Zellen oder Batterien aus solchen Zellen beschränkt, sondern kann grundsätzlich auch bei anderen Batterietechnologien Verwendung finden.

Bei einigen bevorzugten Ausführungsformen der Erfindung ist es wünschenswert, die Batterie so zu steuern, dass einzelne Zellen gesteuert, beispielsweise zu- oder abgeschaltet werden können. Bei solchen Ausführungsformen der Erfindung ist es zweckmäßig, den Batteriezustand durch Betriebszustandsgrößen einzelner Zellen einer Batterie zu charakterisieren, so dass die Steuerung so ausgelegt werden kann, dass sie in der Lage ist, einzelne Zellen in Abhängigkeit von deren Betriebszustand aus einem Batterieverbund ab- und in einen Batterieverbund zuzuschalten.

Zur Durchführung des Verfahrens zur Steuerung von Betriebszuständen einer Batterie kann erfindungsgemäß eine Steuerungsvorrichtung eingesetzt werden, die einen Prozessor und einen Speicher aufweist. Der Prozessor verarbeitet ein Steuerungsprogramm, welches die Steuerung der Betriebszustände auf der Grundlage einer Bewertung von Betriebszuständen durchführt. In dem Speicher sind u.a. die Approximationsfunktionen gespeichert, vorzugsweise in Form ihrer Parameterwerte.

Die vorliegende Erfindung kann außerdem verwirklicht werden durch ein Verfahren zur Konfiguration einer Batterie aus elektrochemischen Zellen, bei dem eine optimale Kombination von Zellen durch Reihen- und/oder Parallelschaltung ermittelt wird auf der Grundlage einer Bewertung von Betriebszuständen der Batterie und/oder einzelner Zellen. Diese Bewertung wird mit Hilfe von Approximationsfunktionen gewonnen, mit deren Hilfe Bewertungen für zweite Betriebszustände durch Interpolation aus Messdaten für erste Betriebszustände ermittelt werden.

Zur Konfiguration einer Batterie werden vorzugsweise die Approximationsfunktionen und ein elektrisches Nutzungsprofil, welches mit dem Anwender abgestimmt oder von diesem definiert wurde, und welches den üblichen oder voraussichtlichen Einsatz der Batterie durch diesen Anwender beschreibt, verwendet, um in Kenntnis weiterer Parameter der Anwendung, wie z.B. der Laufzeit, eine optimale serielle und/oder parallele Verschaltung einzelner Zellen zu ermitteln. Auf diese Weise ist es möglich, die im Nutzungsprofil niedergelegten Anforderungen des Anwenders zu erfüllen, dabei gleichzeitig die Batterie vor unbeabsichtigten Alterungsprozessen oder Schäden zu bewahren und gleichzeitig eine teure Überdimensionierung der Batterie zu vermeiden.

Bei der Nutzungsbereitstellung (Leasing) von Batterien für einen Anwender wird gewöhnlich auf der Basis eines Nutzungsprofils und einer vereinbarten Vertragslaufzeit eine Leasingrate (Nutzungsgebühr) festgelegt. Kommt es nun bei dem Anwender (Kunden) zu dem Fall, dass er die Batterie in einem Betriebszustand nutzt, bei der sie mit größerer Geschwindigkeit als im Vertrag vereinbart oder zugrundegelegt oder vor dem Ende der Vertragslaufzeit altert oder Schaden nimmt, wird dies vom Batteriemanagement gemäß der vorliegenden Erfindung erkannt. Der Anwender kann sich nun entscheiden, ob er wünscht, dass die Schutzelektronik eingreift und die Batterie abschaltet oder ihre Leistung auf ein nichtschädliches Niveau begrenzt; er hat aber auch die Möglichkeit, gegen einen Preisaufschlag in der Nutzungsgebühr (Leasingrate) Betriebszustände zu nutzen, die von der Norm des vereinbarten Nutzungsprofils abweichen. Damit hat der Anwender eine höhere Flexibilität und kann die Batterie auch außerhalb der im Vertrag vorgesehenen Betriebszustände nutzen.

## Patentansprüche

1. Verfahren zur Steuerung von Betriebszuständen einer Batterie aus elektrochemischen Zellen, bei dem die Steuerung der Betriebszustände auf der Grundlage einer Bewertung von Betriebszuständen erfolgt, wobei diese Bewertung mit Hilfe von Approximationsfunktionen gewonnen wird, mit deren Hilfe Bewertungen für zweite Betriebszustände, für die keine oder keine vollständigen Messdaten über das Verhalten der Batterie vorliegen, durch Interpolation zwischen oder durch Extrapolation aus Messdaten für erste Betriebszustände, für die Messdaten über das Verhalten der Batterie vorliegen, ermittelt werden,
wobei die Bewertung eines Betriebszustandes wenigstens ein quantitatives Maß für die Alterung oder Schädigung von Zellen in diesem Betriebszustand enthält, und wobei die Steuerung eine Zielgröße optimiert, die neben wenigstens dem quantitativen Maß für die Alterung oder Schädigung von Zellen noch mindestens die elektrische Leistung der Batterie, die voraussichtliche Restlebensdauer oder die Restkapazität der Batterie enthält.

2. Verfahren nach Anspruch 1, bei dem die Steuerung so ausgelegt ist, dass ein quantitatives Maß für die Alterung oder Schädigung von Zellen minimiert wird.

3. Verfahren nach einem der vorhergehenden Ansprüche, bei dem die Steuerung eine Zielgröße optimiert, die neben wenigstens einem quantitativen Maß für die Alterung oder Schädigung von Zellen noch mindestens eine weitere Funktion von Betriebszustandsgrößen der Batterie umfasst.

4. Verfahren nach einem der vorhergehenden Ansprüche, bei dem Batteriebetriebszustände durch mindestens eine der Betriebszustandgrößen Spannung, Widerstand, Temperatur, Ladestrom oder Entladestrom charakterisiert werden.

5. Verfahren nach einem der vorhergehenden Ansprüche, bei dem Approximationsfunktionen verwendet werden, die durch Approximation parametrischer Funktionen an Alterungsmessdaten gewonnen wurden, die bei verschiedenen ersten Betriebszuständen der zu steuernden Batterie gemessen wurden.

6. Verfahren nach einem der vorhergehenden Ansprüche, bei dem ein Batteriezustand durch Betriebszustandsgrößen einzelner Zellen einer Batterie charakterisiert ist, und bei dem die Steuerung einzelne Zellen in Abhängigkeit von deren Betriebszustand aus einem Batterieverbund ab- und in einen Batterieverbund zuschalten kann.

7. Verfahren nach einem der vorhergehenden Ansprüche, bei dem Bewertungen von Betriebszuständen mit Hilfe nicht linearer Approximationsfunktionen gewonnen werden.

8. Verfahren nach einem der vorhergehenden Ansprüche, bei dem Bewertungen von Betriebszuständen mit Hilfe von Approximationsfunktionen gewonnen werden, deren funktionale Form durch physikalische oder chemische Modelle über funktionale Zusammenhänge zwischen Betriebszustandsgrößen einer Batterie gegeben oder beeinflusst ist.

9. Vorrichtung zur Steuerung von Betriebszuständen einer Batterie aus elektrochemischen Zellen mit
a) einem Prozessor, der eingerichtet ist, ein Steuerungsprogramm zu verarbeiten, welches die Steuerung der Betriebszustände auf der Grundlage einer Bewertung von Betriebszuständen durchführt, wobei diese Bewertung mit Hilfe von Approximationsfunktionen gewonnen wird, mit deren Hilfe Bewertungen für zweite Betriebszustände durch Interpolation zwischen oder durch Extrapolation aus Messdaten für erste Betriebszustände ermittelt werden, und mit
b) einem Speicher, in dem Parameterwerte von Approximationsfunktionen gespeichert sind,
wobei die Bewertung eines Betriebszustandes wenigstens ein quantitatives Maß für die Alterung oder Schädigung von Zellen in diesem Betriebszustand enthält, und wobei die Steuerung eingerichtet ist, eine Zielgröße zu optimieren, die neben wenigstens dem quantitativen Maß für die Alterung oder Schädigung von Zellen noch mindestens die elektrische Leistung der Batterie, die voraussichtliche Restlebensdauer oder die Restkapazität der Batterie enthält.

10. Verfahren zur Konfiguration einer Batterie aus elektrochemischen Zellen, bei dem eine optimale Kombination von Zellen durch Reihen- und/oder Parallelschaltung ermittelt wird auf der Grundlage einer Bewertung von Betriebszuständen der Batterie und/oder einzelner Zellen,
wobei diese Bewertung mit Hilfe von Approximationsfunktionen gewonnen wird, mit deren Hilfe Bewertungen für zweite Betriebszustände durch Interpolation zwischen oder durch Extrapolation aus Messdaten für erste Betriebszustände ermittelt werden,
wobei die Bewertung eines Betriebszustandes wenigstens ein quantitatives Maß für die Alterung oder Schädigung von Zellen in diesem Betriebszustand enthält, und wobei
eine Steuerung eine Zielgröße optimiert, die neben wenigstens einem quantitativen Maß für die Alterung oder Schädigung von Zellen noch mindestens die elektrische Leistung der Batterie, die voraussichtliche Restlebensdauer oder die Restkapazität der Batterie enthält.

## Claims

1. Method for controlling operating states of a battery of electrochemical cells, wherein the operating states are controlled on the basis of an evaluation of operating states, this evaluation being obtained by means of approximation functions with the aid of which evaluations for second operating states for which no or only incomplete measuring data relating to the behaviour of the battery are available are obtained by interpolation between or extrapolation from measuring data for first operating states for which measuring data relating to the behaviour of the battery are available,
wherein the evaluation of an operating state includes at least one quantitative measure for the ageing or damage of cells in this operating state, and
wherein the control optimises a target variable which, in addition to at least the quantitative measure for the ageing or damage of cells, includes at least the electric power of the battery, the expected remaining service life or the remaining capacity of the battery.

2. Method according to claim 1, wherein the control is configured such that a quantitative measure for the ageing or damage of cells is minimised.

3. Method according to any of the preceding claims, wherein the control optimises a target variable which, in addition to at least one quantitative measure for the ageing or damage of cells, includes at least one further function of operating state variables of the battery.

4. Method according to any of the preceding claims, wherein battery operating states are **characterised by** at least one of the operating state variables of voltage, resistance, temperature, charging or discharging current.

5. Method according to any of the preceding claims, wherein approximation functions are used which are gained by the approximation of parametric functions on ageing data which are measured at various first operating states of the battery to be controlled.

6. Method according to any of the preceding claims, wherein a battery state is **characterised by** operating state variables of individual cells of a battery, and wherein the control can remove individual cells from or add individual cells to a battery compound depending on their operating state.

7. Method according to any of the preceding claims, wherein evaluations of operating states are obtained by means of non-linear approximation functions.

8. Method according to any of the preceding claims, wherein evaluations of operating states are obtained by means of approximation functions, the functional form of which is determined or influenced by physical or chemical models relating to functional relationships between operating state variables of a battery.

9. Device for controlling operating states of a battery of electrochemical cells, comprising
a) a processor configured to process a control programme which controls the operating states on the basis of an evaluation of operating states, this evaluation being obtained by means of approximation functions with the aid of which evaluations for second operating states are obtained by interpolation between or extrapolation from measuring data for first operating states, and
b) a memory in which parametric values of approximation functions are stored,
wherein the evaluation of an operating state includes at least one quantitative measure for the ageing or damage of cells in this operating state, and
wherein the control is configured to optimise a target variable which, in addition to at least the quantitative measure for the ageing or damage of cells, includes at least the electric power of the battery, the expected remaining service life or the remaining capacity of the battery.

10. Method for configuring a battery of electrochemical cells, wherein an optimum combination of cells is determined by series and/or parallel connection on the basis of an evaluation of operating states of the battery and/or of individual cells,
wherein this evaluation is obtained by means of approximation functions with the aid of which evaluations for second operating states are obtained by interpolation between or extrapolation from measuring data for first operating states,
wherein the evaluation of an operating state includes at least one quantitative measure for the ageing or damage of cells in this operating state, and
wherein a control optimises a target variable which, in addition to at least quantitative measure for the ageing or damage of cells, includes at least the electric power of the battery, the expected remaining service life or the remaining capacity of the battery.

## Revendications

1. Procédé de commande d'états de fonctionnement d'une batterie composée de cellules électrochimiques, la commande des états de fonctionnement s'effectuant en fonction d'une évaluation des états de fonctionnement, ladite évaluation étant obtenue à l'aide de fonctions d'approximation, à l'aide desquelles des évaluations sont déterminées pour des seconds états de fonctionnement pour lesquels il n'existe aucune donnée de mesure ou aucune donnée de mesure complète concernant le comportement de la batterie par interpolation entre des données de mesure ou par extrapolation à partir de données de mesure pour les premiers états de fonctionnement, pour lesquels des données de mesure concernant le comportement de la batterie existent, l'évaluation d'un état de fonctionnement contenant au moins un degré quantitatif pour le vieillissement ou le dommage des cellules dans ledit état de fonctionnement et la commande optimisant un paramètre cible qui contient en outre au moins du degré quantitatif pour le vieillissement ou le dommage des cellules encore au moins la puissance électrique de la batterie, la durée de vide restante prévisible ou la capacité restante de la batterie.

2. Procédé selon la revendication 1, la commande étant conçue de telle sorte qu'un degré quantitatif pour le vieillissement ou le dommage des cellules soit réduit au minimum.

3. Procédé selon l'une quelconque des revendications précédentes, la commande optimisant un paramètre cible comprend en outre au moins d'un degré quantitatif pour le vieillissement ou le dommage des cellules une autre fonction des paramètres d'état de fonctionnement de la batterie.

4. Procédé selon l'une quelconque des revendications précédentes, les états de fonctionnement de la batterie étant **caractérisés par** au moins l'un des paramètres d'état de fonctionnement de batterie suivants : tension, résistance, température, courant de charge ou courant de décharge.

5. Procédé selon l'une quelconque des revendications précédentes, selon lequel les fonctions d'approximation qui sont obtenues à partir de l'approximation des fonctions paramétriques par rapport aux données de mesure de vieillissement, qui ont été mesurées lors des premiers états de fonctionnement de la batterie à commander, sont utilisées.

6. Procédé selon l'une quelconque des revendications précédentes, un état de batterie étant **caractérisé par** des paramètres d'état de fonctionnement de chacune des cellules d'une batterie et selon lequel la commande peut arrêter chacune des cellules en fonction de leur état de fonctionnement à partir d'un ensemble batterie et les commuter dans un ensemble batterie.

7. Procédé selon l'une quelconque des revendications précédentes, les évaluations des états de fonctionnement étant obtenues à l'aide de fonctions d'approximation non linéaires.

8. Procédé selon l'une quelconque des revendications précédentes, des évaluations des états de fonctionnement étant obtenues à l'aide de fonctions d'approximation dont la forme fonctionnelle est donnée ou influencée par des modèles physiques ou chimiques par le biais de rapports fonctionnels entre des paramètres d'états de fonctionnement d'une batterie.

9. Dispositif de commande d'états de fonctionnement d'une batterie composée de cellules électrochimiques comprenant :
a) un processeur qui est conçu pour traiter un programme de commande, ledit programme exécute la commande des états de fonctionnement en fonction d'une évaluation des états de fonctionnement, ladite évaluation étant obtenue à l'aide de fonctions d'approximation, à l'aide desquelles des évaluations sont déterminées pour des seconds états de fonctionnement par interpolation entre des données de mesure ou par extrapolation à partir de données de mesure pour les premiers états de fonctionnement, et
b) une mémoire dans laquelle des valeurs de paramètres des fonctions d'approximation sont mémorisées, l'évaluation d'un état de fonctionnement contenant au moins un degré quantitatif pour le vieillissement ou le dommage des cellules dans ledit état de fonctionnement et la commande étant conçue pour optimiser un paramètre cible qui contient en outre au moins du degré quantitatif pour le vieillissement ou le dommage des cellules encore au moins la puissance électrique de la batterie, la durée de vide restante prévisible ou la capacité restante de la batterie.

10. Procédé de configuration d'une batterie composée de cellules électrochimiques, une combinaison optimale des cellules étant déterminée par un montage en série et/ou en parallèle en fonction d'une évaluation des états de fonctionnement de la batterie et/ou de chacune des cellules, ladite évaluation étant obtenue à l'aide des fonctions d'approximation, à l'aide desquelles des évaluations étant déterminées pour des seconds états de fonctionnement par interpolation entre des données de mesure ou par extrapolation à partir des données de mesure pour des premiers états de fonctionnement, l'évaluation d'un état de fonctionnement contenant au moins un degré quantitatif pour le vieillissement ou le dommage des cellules dans ledit état de fonctionnement, et une commande optimisant un paramètre cible, qui contient en outre au moins d'un degré quantitatif pour le vieillissement ou le dommage des cellules au moins la puissance électrique de la batterie, la durée de vie restante prévisible ou la capacité restante de la batterie.
